# EUROPÄISCHE PATENTSCHRIFT

(11) **EP 0 489 052 B1**
(45) Veröffentlichungstag und Bekanntmachung des Hinweises auf die Patenterteilung: **12.05.1993**
(21) Anmeldenummer: 90912359.8
(22) Anmeldetag: 22.08.1990
(51) Int. Cl.: G01R 31/28, G01R 1/067

(54) **VORRICHTUNG FÜR DIE ELEKTRISCHE FUNKTIONSPRÜFUNG VON VERDRAHTUNGSFELDERN, INBESONDERE VON LEITERPLATTEN**
DEVICE FOR THE OPERATIONAL ELECTRICAL TESTING OF WIRED AREAS, ESPECIALLY PRINTED CIRCUIT BOARDS
DISPOSITIF POUR LE CONTROLE DU FONCTIONNEMENT ELECTRIQUE DE CHAMPS DE CABLAGE, EN PARTICULIER DE CARTES DE CIRCUITS IMPRIMES

(30) Priorität: 23.08.1989 DE 3927842
(43) Veröffentlichungstag der Anmeldung: 10.06.1992
(73) Patentinhaber: Siemens Nixdorf Informationssysteme Aktiengesellschaft, 33102 Paderborn (DE)
(72) Erfinder: ROSE, Thomas, D-8000 München 70 (DE); HOFFMANN, Detlef, D-8037 Neu-Esting (DE)
(74) Vertreter: Fuchs, Franz-Josef, Dr.-Ing.
(86) Internationale Anmeldenummer: DE9000641
(87) Internationale Veröffentlichungsnummer: WO9102986

(56) Entgegenhaltungen:
- EP-A- 0 102 565
- EP-A- 0 285 798
- EP-A- 0 322 607

## Beschreibung

Die Erfindung betrifft eine Vorrichtung für die elektrische Funktionsprüfung von Verdrahtungsfeldern, insbesondere von Leiterplatten, die eine Vielzahl von mit einem relativ großen Abstand voneinander angeordneten ersten Meßstellen und mindestens eine Gruppe von mit feinerem Abstand voneinander angeordneten zweiten Meßstellen aufweisen.

In Prüfautomaten und Prüfadaptern für unbestückte und bestückte Leiterplatten sowie für Verdrahtungsfelder in Löt- oder Crimptechnik wird die Kontaktierung der ausgewählten Meßstellen in der Regel über federnde Prüfspitzen vorgenommen. Die entsprechend dem Rastermaß eines zu prüfenden Verdrahtungsfeldes angeordneten federnden Prüfspitzen werden mittels Federhülsen befestigt, die in eine Trägerplatte eingepreßt sind und in die man die Prüfspitzen einschiebt. Bei der Auswahl der Prüfspitzen entscheiden üblicherweise der kleinste Abstand der Meßstellen zueinander sowie die Strombelastung über den Durchmesser der federnden Prüfspitzen, wobei als unteres Grenzmaß für den Durchmesser jedoch 0,38 mm genannt werden (Productronic, Mai 1989, Seiten 36 bis 40).

Mit den bekannten Vorrichtungen für die elektrische Funktionsprüfung von Leiterplatten werden zwischen den durch Rasterpunkte entsprechend dem Layout gebildeten Prüfstellen Leitfähigkeits- und Isolationsmessungen durchgpführt. Da die für die Ankontaktierung der Prüfstellen vorgesehenen federnden Prüfspitzen im Raster der Leiterplatte angeordnet werden müssen, stößt die Realisierung derartiger Vorrichtungen bei abnehmendem Rastermaß und größer werdenden Flächen der Leiterplatten zunehmend auf prinzipielle Schwierigkeiten. So ist eine Anordnung der federnden Prüfspitzen in Rastermaßen unter einem Milimeter bei einer sicheren mechanischen Kontaktierung der Prüfstellen feinwerktechnisch kaum mehr beherrschbar. Mit der Anzahl der Meßstellen, die beispielsweise Hunderttausend betragen kann, steigt auch die Anzahl der erforderlichen Zuleitungen und Schaltelemente, wodurch eine erheblicher gerätetechnischer Aufwand und entsprechend hohe Kosten verursacht werden. Außerdem nimmt mit der Anzahl der Meßstellen auch die Wahrscheinlichkeit einer vollständigen Kontaktierung der Leiterplatten erheblich ab.

Aus der EP-B-O 102 565 ist eine Vorrichtung für die elektrische Funktionsprüfung von Verdrahtungsfeldern bekannt, bei welcher die bisher übliche ohm'sche Kontaktierung der Meßstellen durch eine berührungslose ionische Kontaktierung über Gasentladungsstrecken ersetzt wird. Hierzu wird in eine auf die Verdrahtungsfelder aufsetzbare Trägerplatte eine Vielzahl von mit Elektroden versehenen Gasentladungskanälen eingebracht, wobei die im Raster der Verdrahtungsfelder angeordneten Gasentladungskanäle zu den Meßstellen hin offen sind. Sind nun zwei ausgewählte Meßstellen beispielsweise durch eine Leiterbahn elektrisch leitend miteinander verbunden, so bilden die zugeordneten Gasentladungskanäle zwei in Reihe geschaltete Gasentladungsstrecken, die durch Anlegen einer hinreichend hohen Spannung an die Elektroden gezündet werden können. Mit der Zündung der Gasentladungen erfolgt dann ein Stromtransport, der zu Prüfzwecken ausgewertet werden kann. Unterbleibt die Zündung der Gasentladungen oder fließt nach einer Zündung ein zu geringer Strom, so kann auf eine unterbrochene oder von vorneherein nicht existierende elektrisch leitende Verbindung zwischen den ausgewählten Meßstellen geschlossen werden. Wird der an die Elektroden angelegten Spannung eine Wechselspannung überlagert, so kann die daraus resultierende Stromänderung phasenempfindlich zur angelegten Wechselspannung gemessen und für die Bestimmung des Widerstandes einer zwischen den ausgewählten Meßstellen bestehenden Verbindung herangezogen werden. Die bekannte Vorrichtung ermöglicht also Leitfähigkeits- und Isolationsmessungen, wobei durch das Vermeiden von ohm'schen Kontakten eine sehr hohe Zuverlässigkeit erreicht wird. Durch das Prinzip der ionischen Kontaktierung der Meßstellen über in äußerst geringen Abmessungen realisierbare Gasentladungskanäle können dann insbesondere Verdrahtungsfelder mit kleinen Rastermaßen der Meßstellen bis herab zu 0,1 mm zuverlässig geprüft werden.

Bei der aus der EP-B-O 102 565 bekannten Vorrichtung ist für jede Meßstelle also ein eigener Gasentladungskanal in der Trägerplatte vorgesehen. Dies ist insbesondere dann notwendig, wenn mit derselben Vorrichtung unterschiedliche Verdrahtungsfelder geprüft werden sollen.

Es gibt nun aber spezielle Verdrahtungsfelder oder Leiterplatten oder Teilbereiche davon, die z.B. zum direkten Kontaktieren von gehäuselosen integrierten Schaltungen bestimmt sind und die folgende charakteristische Struktur aufweisen. Sie enthalten Bereiche von Meßstellen mit einem Abstand voneinander, der noch kleiner ist als der Abstand unter den übrigen Meßstellen, die in dem üblichen Abstand bzw. Raster voneinander angeordnet sind. Diese geringe Abstand stimmt z.B. mit dem Anschlußraster der vorstehend erwähnten gehäuselosen integrierten Schaltungen überein. Typischerweise existiert bei derartigen Verdrahtungsfeldern oder Leiterplatten genau eine leitende Verbindung zwischen einer Meßstelle des Feinbereichs und einer Meßstelle des hier als Grobbereich bezeichneten Bereichs der übrigen Meßstellen. Als Beispiel können die Filme der MIKROPACK-Bauform für SMD-IC's der Siemens Aktiengesellschaft, Berlin und München, DE genannt werden, bei denen der Abstand der Meßstellen im Feinbereich kleiner als 100 µm sein kann.

Unterschreitet das Rastermaß der Meßstellen im Feinbereich 100 µm, so kann die sichere Ankontaktierung dieser Meßstellen über zugeordnete Gasentladungskanäle Probleme bereiten. Darüber hinaus wachsen die Anforderungen an die Justiergenauigkeit der Trägerplatten relativ zum Verdrahtungsfeld, die bei einem Rasterabstand von 100 µm besser als 10 µm sein müßte. Dies führt entweder zu einer längeren Prüfzeit oder zu höheren Herstellungskosten der für die Funktionsprüfung eingesetzten Vorrichtung.

Der Erfindung liegt die Aufgabe zugrunde, die aus der EP-A-O 102 565 bekannte Vorrichtung für die elektrische Funktionsprüfung von Leiterplatten so zu verbessern, daß bei vertretbarem Fertigungsaufwand auch Gruppen von Meßstellen mit Abständen von weniger als 100 µm einfach adaptierbar sind und die Anforderungen an die Justiergenauigkeit gesenkt werden können.

Diese Aufgabe wird erfindungsgemäß durch die im Anspruch 1 aufgeführten Merkmale gelöst.

Bei der erfindungsgemäßen Vorrichtung werden die zweiten Meßstellen im Feinbereich also nicht über jeweils zugeordnete separate Gasentladungskanäle kontaktiert. Die Gruppe von zweiten Meßstellen wird vielmehr gemeinsam über einen einzigen ausgedehnten Entladungskanal, den Gruppen-Gasentladungskanal, der den ganzen Feinbereich überdeckt, kontaktiert. Dadurch wird auch die Anzahl der notwendigen Elektroden, Zuleitungen und Koppeleinrichtungen um etwa die Hälfte vermindert. Ein Verdrahtungsfeld oder eine Leiterplatte können auch zwei oder mehrere Gruppen von zweiten Meßstellen aufweisen, wobei dann jeder dieser Gruppen ein eigener Gruppen-Gasentladungskanal zugeordnet ist.

Bei einer Gruppe von in einer Reihe nebeneinander angeordneten zweiten Meßstellen ist der zugeordnete Gruppen-Gasentladungskanal vorzugsweise in Form eines Langloches in den Träger eingebracht. Hierdurch ergibt sich eine optimale Anpassung der Geometrie des Gruppen-Gasentladungskanals an die Gruppe von zweiten Meßstellen.

Weiterhin hat es sich als vorteilhaft erwiesen, wenn die Gruppen-Elektrode durch eine den Gruppen-Gasentladungskanal überquerende Leitung gebildet ist. In diesem Fall dient dann die Fortsetzung der Gruppen-Elektrode als Anschlußleitung. Die Herstellung der Gruppen-Elektroden kann dann auch ebenso wie die Herstellung der ersten Elektroden mit auf dem Gebiet der gedruckten Schaltungen oder Schichtschaltungen'üblichen Techniken vorgenommen werden.

In manchen Fällen gibt es erste Meßstellen im Grobbereich, die mit mehreren zweiten Meßstellen im Feinbereich verbunden sind. Auch in diesen Fällen wird eine elektrische Funktionsprüfung ermöglicht, durch eine Einrichtung zur quantitativen Erfassung von Prüfstrom und Prüfspannung zwischen einer ersten Elektrode' und einer Gruppen-Elektrode und zur Ermittlung der Gesamtfläche oder der Gesamtzahl der kontaktierten zweiten Meßstellen in Abhängigkeit von Prüfstrom und Prüfspannung. Hier wird also die Abhängigkeit der Strom-Spannungskennlinie von der Kathodenfläche ausgenützt.

Ausführungsbeispiele der Erfindung sind in der Zeichnung dargestellt und werden im folgenden näher beschrieben.

Es zeigen
- Fig. 1: das Prinzip einer erfindungsgemäßen Vorrichtung für die elektrische Funktionsprüfung von Leiterplatten,
- Fig. 2: die Ermittlung eines speziellen Fehlers einer zu prüfenden Leiterplatte und
- Fig. 3: die Prüfung einer Leiterplatte, bei welcher Meßstellen im Grobbereich mit mehreren Meßstellen im Feinbereich verbunden sind.

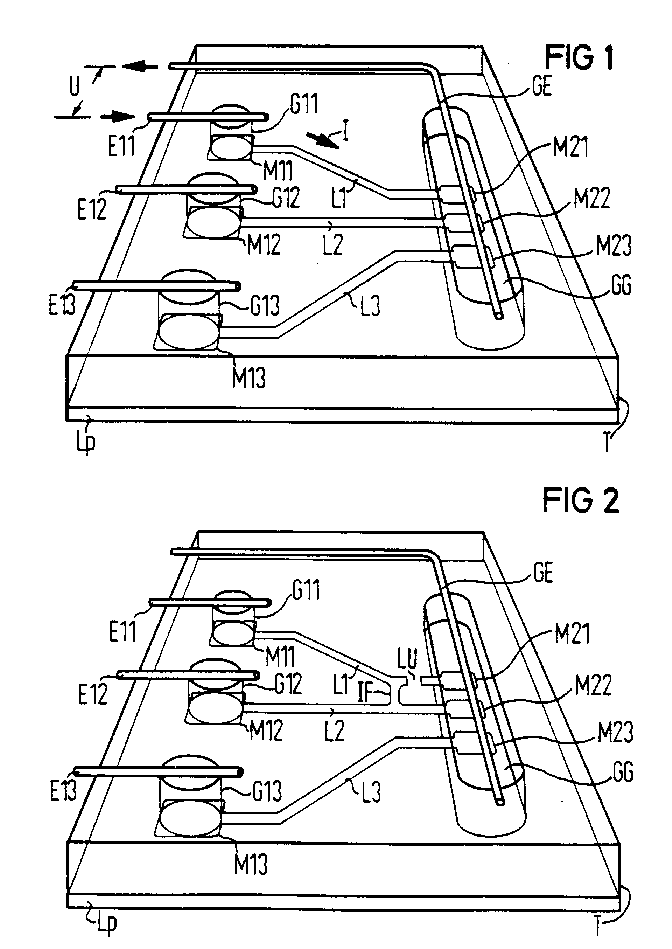

Fig. 1 zeigt eine zu prüfende Leiterplatte Lp mit ersten Meßstellen M11, M12 und M13 im Grobrasterbereich und mit einer Gruppe von zweiten Meßstellen M21, M22 und M23 im Feinrasterbereich. Dabei sind die Meßstellen M11 und M21, M12 und M22 sowie M13 und M23 über Leiterbahnen L1 bzw. L2 bzw. L3 elektrisch leitend miteinander verbunden. Mit der in Fig. 1 dargestellten Leiterplatte Lp soll lediglich das Prinzip der erfindungsgemäßen elektrischen Funktionsprüfung aufgezeigt werden. In Wirklichkeit kann die Leiterplatte Lp beispielsweise eine Anzahl von 100.000 ersten Meßstellen und auch mehrere Gruppen von zweiten Meßstellen aufweisen.

Zur elektrischen Funktionsprüfung der Leiterplatte Lp wird auf deren Oberseite eine Trägerplatte T aufgesetzt, die aus einem elektrisch isolierenden Material wie z.B. Glas besteht. In die Trägerplatte T sind in Form von zylindrischen Löchern erste Gasentladungskanäle G11, G12 und G13 eingebracht, die den ersten Meßstellen M11 bzw. M12 bzw. M13 zugeordnet sind und demgemäß das gleiche Raster wie die ersten Meßstellen aufweisen. Jeder der Gasentladungskanäle G11, G12 und G13 ist mit einer separaten ersten Elektrode E11 bzw. E12 bzw. E13 ausgerüstet. Die ersten Elektroden sind im dargestellten Ausführungsbeispiel als zylindrische Drähte ausgebildet, die auf der Oberseite der Trägerplatte T die ersten Gasentladungskanäle mittig überqueren.

In die Trägerplatte T ist ferner in Form eines Langloches ein Gruppen-Gasentladungskanal GG eingebracht, der der Gesamtheit der zweiten Meßstellen M21, M22 und M23 zugeordnet ist und den gesamten Feinrasterbereich überdeckt. Dieser Gruppen-Gasentladungskanal GG ist mit einer Gruppen-Elektrode GE versehen, die im dargestellten Ausführungsbeispiel wiederum als zylindrischer Draht ausgebildet ist, der auf der Oberseite der Trägerplatte T den Gruppen-Gasentladungskanal GG in Längsrichtung mittig überquert.

Soll nun beispielsweise die elektrisch leitende Verbindung L1 zwischen der ersten Meßstelle M11 im Grobrasterbereich und der zweiten Meßstellen M21 im Feinrasterbereich geprüft werden, so wird an die erste Elektrode E11 und die Gruppen-Elektroden GE eine hinreichend hohe Prüfspannung U angelegt. Bei intakter Verbindung L1 zünden die Gasentladungen im ersten Gasentladungskanal G11 zwischen der ersten Elektrode E11 und der ersten Meßstelle M11 und im Gruppen-Gasentladungskanal GG zwischen der zweiten Meßstelle M21 und der Gruppen-Elektrode GE. Die Gasentladung sucht sich sozusagen automatisch ihren Weg von der Gruppen-Elektrode GE zu der zweiten Meßstelle M21, deren zugehörige erste Meßstelle M11 kontaktiert wurde. Aus dem resultierenden Stromfluß I kann dann auf das Vorhandensein der elektrisch leitenden Verbindung L1 geschlossen werden.

Soll die Isolation beispielsweise zwischen den Leiterbahnen L1 und L2 geprüft werden, so wird die Prüfspannung an die ersten Elektroden E11 und E12 angelegt. Aus einem Stromfluß kann dann in diesem Fall auf einen Isolationsfehler geschlossen werden.

In Fig. 2 ist ein spezieller Fehler dargestellt, bei welchem einerseits die Leiterbahn L1 eine Leiterbahnunterbrechung LU aufweist und andererseits eine fehlerhafte Isolation IF zwischen den Leiterbahnen L1 und L2 vorliegt. In diesem Fall wird bei der Durchgangsprüfung zwischen der ersten Elektrode E11 und der Gruppen-Elektrode GE eine intakte Verbindung L1 vorgetäuscht. Beim Isolationstest zwischen dem ersten Elektroden E11 und E12 wird der Fehler jedoch sicher registriert.

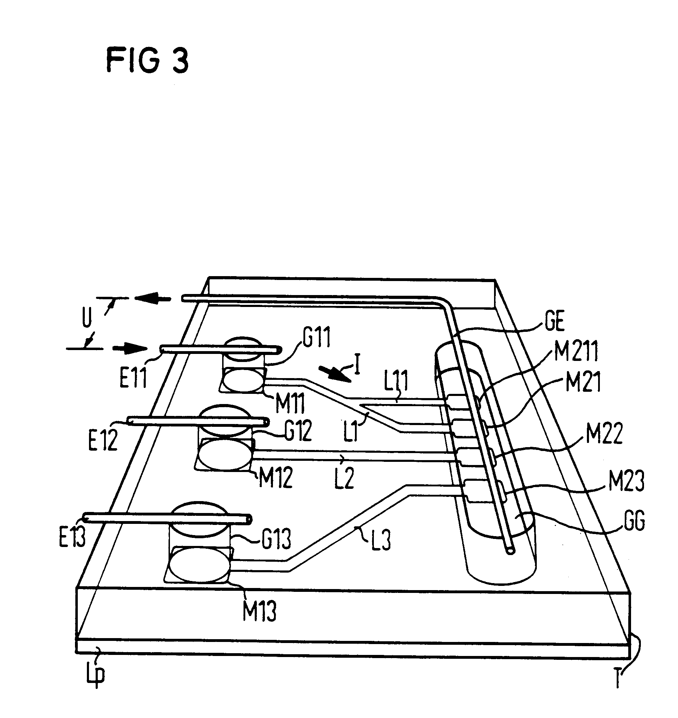

Gemäß Fig. 3 gibt es auch Verdrahtungsfelder bzw. Leiterplatten Lp mit ersten Meßstellen im Grobrasterbereich, die mit mehreren zweiten Meßstellen im Feinrasterbereich verbunden sind. Im dargestellten Fall ist die erste Meßstelle M11 über die Leiterbahn L1 mit der zweiten Meßstelle M21 und über eine abzweigende Leiterbahn L11 mit der zweiten Meßstelle M211 verbunden. Wird nun zwischen der ersten Elektrode E11 und der Gruppen-Elektrode GE eine Prüfspannung U angelegt, so fließt ein Strom I auch dann, wenn nur eine der Verbindungen L1 und L11 intakt ist. Da die Strom-Spannungskennlinie der Gasentladungen jedoch von der Kathodenfläche abhängig ist, läßt sich ein Parameterbereich finden, in dem bei vorgegebener Prüfspannung U der Prüfstrom I bzw. bei vorgegebenem Prüfstrom I die Prüfspannung U ein Maß für die Gesamtfläche der kontaktierten zweiten Meßstellen M211 und M21 im Gruppen-Gasentladungskanal GG darstellt. Bei bekannter Fläche der einzelnen zweiten Meßstellen läßt sich dann die Anzahl der zweiten Meßstellen ermitteln, die von der Gasentladung beaufschlagt werden. Damit läßt sich beantworten, mit wieviel zweiten Meßstellen eine erste Meßstelle elektrisch leitend verbunden ist. Im dargestellten Fall kann dann ausgesagt werden, ob die erste Meßstelle M11 sowohl mit der zweiten Meßstelle M21 als auch mit der zweiten Meßstelle M211 elektrisch leitend verbunden ist.

Mit der vorstehend beschriebenen Vorrichtung ist also eine vollständige elektrische Funktionsprüfung von Verdrahtungfeldern oder Leiterplatten möglich, wobei die Größe der Entladungskanäle unabhängig vom Feinraster wird. Damit ist es möglich, bei Verdrahtungsfeldern oder Leiterplatten vom vorstehend beschriebenen Typ Meßstellen mit beliebig kleinem Abstand voneinander zu kontaktieren.

Weitere Einzelheiten über die elektrische Funktionsprüfung von Verdrahtungsfeldern durch ionische Kontaktierung der Meßstellen über Gasentladungskanäle gehen aus der vorstehend bereits erwähnten EP-B-O 102 565 hervor.

## Patentansprüche

1. Vorrichtung für die elektrische Funktionsprüfung von Verdrahtungsfeldern, insbesondere von Leiterplatten (Lp), die eine Vielzahl von mit einem relativ großen Abstand voneinander angeordneten ersten Meßstellen (M11,M12,M13) und mindestens eine Gruppe von mit feinerem Abstand voneinander angeordneten zweiten Meßstellen (M21,M22,M23,M211) aufweisen, mit
- einer auf die Verdrahtungsfelder aufsetzbaren Trägerplatte (T), in welche
- den ersten Meßstellen (M11,M12,M13) zugeordnete und jeweils mit ersten Elektroden (E11,E12,E13) versehene erste Gasentladungskanäle (G11,G12,G13) und
- ein der Gruppe von zweiten Meßstellen (M21,M22,M23,M211) zugeordneter und mit einer Gruppen-Elektrode (GE) versehener Gruppen-Gasentladungskanal (GG) eingebracht sind, wobei
- jeweils mindestens zwei ausgewählte Meßstellen (M11,M21;M11, M21,M211) eines Verdrahtungsfeldes über die zugeordneten Gasentladungskanäle (G11,GG) und deren Elektroden (E11,GE) ionisch kontaktierbar sind.

2. Vorrichtung nach Anspruch 1,
**dadurch gekennzeichnet**,
daß der einer Gruppe von in einer Reihe nebeneinander angeordneten zweiten Meßstellen (M21,M22,M23,M211) zugeordnete Gruppen-Gasentladungskanal (GG) in Form eines Langloches in den Träger (T) eingebracht ist.

3. Vorrichtung nach Anspruch 1 oder 2,
**dadurch gekennzeichnet**,
daß die Gruppen-Elektrode (GE) durch eine den Gruppen-Gasentladungskanal (GG) überquerende Leitung gebildet ist.

4. Vorrichtung nach einem der vorhergehenden Ansprüche,
**gekennzeichnet** **durch**
eine Einrichtung zur quantitativen Erfassung von Prüfstrom (I) und Prüfspannung (U) zwischen einer ersten Elektrode (E11) und einer Gruppen-Elektrode (GE) und zur Ermittlung der Gesamtfläche oder der Gesamtzahl der kontaktierten zweiten Meßstellen (M21, M211) in Abhängigkeit von Prüfstrom (I) und Prüfspannung (U).

## Claims

1. Device for the operational electrical testing of wiring areas, especially of circuit boards (Lp) which exhibit a multiplicity of first test points (M11,M12,M13) arranged at a relatively large distance from one another and at least one group of second test points (M21,M22, M23,M211) arranged at a closer distance from one another, comprising
- a carrier plate (T) which can be placed onto the wiring areas, into which plate
- first gas discharge ducts (G11,G12,G13) associated with the first test points (M11,M12,M13) and in each case provided with first electrodes (E11,E12,E13), and
- a group gas discharge duct (GG) associated with the group of second test points (M21,M22,M23,M211) and provided with a group electrode (GE) are inserted, it being possible
- in each case for at least two selected test points (M11,M21;M11,M21,M211) of a wiring area to be ionically contacted via the associated gas discharge ducts (G11,GG) and their electrodes (E11,EG).

2. Device according to claim 1, characterised in that the group gas discharge duct (GG) allocated to one group of second test points (M21,M22,M23,M211) arranged in a row next to one another is inserted into the carrier (T) in the form of an elongated hole.

3. Device according to Claim 1 or 2, characterised in that the group electrode (GE) is formed by a line crossing the group gas discharge duct (GG).

4. Device according to one of the preceding claims, characterised by a facility for quantitatively detecting test current (I) and test voltage (U) between a first electrode (E11) and a group electrode (GE) and for determining the total area or the total number of contacted second test points (M21, M211) as a function of test current (I) and test voltage (U).

## Revendications

1. Dispositif pour le contrôle électrique de fonctionnement de champs de câblage, notamment des plaques à circuits imprimés (Lp), qui comportent un grand nombre de premiers points de mesure (M11,M12,M13) disposés les uns des autres à une distance relativement grande et au moins un groupe de deuxièmes points de mesure (M21,M22,M23,M211) disposés les uns des autres à une distance plus faible, qui comporte
- une plaque de support (T) susceptible d'être placée sur le champ de câblage, et dans laquelle sont réalisés
- des premiers canaux de décharge gazeuse (G11,G12,G13) associés aux premiers points de mesure (M11,M12,M13) et respectivement munis de premières électrodes (E11,E12,E13) et
- un canal de décharge gazeuse de groupe (GG) associé au groupe de deuxièmes points de mesure (M21,M22,M23,M211) et muni d'une électrode de groupe (GE),
- respectivement au moins deux points de mesure (M11,M21; M11,M21,M211) sélectionnés d'un champ de câblage, étant susceptible d'être contactés ioniquement par l'intermédiaire des canaux de décharge gazeuse (G11,GG) associés et leurs électrodes (E11,GE).

2. Dispositif selon la revendication 1, caractérisé en ce que
le canal de décharge gazeuse de groupe (GG) associé à un groupe de deuxièmes points de mesure (M21,M22,M23,M211) disposés en série les uns à côté des autres, est réalisé sous la forme d'un trou oblong dans le support (T).

3. Dispositif selon la revendication 1 ou 2, caractérisé en ce que
l'électrode de groupe (GE) est formée par un conducteur traversant obliquement le canal de décharge gazeuse de groupe (GG).

4. Dispositif selon l'une des revendications précédentes, caractérisé par
un dispositif pour détecter quantitativement le courant de contrôle (I) et la tension de contrôle (U) entre une première électrode (E11) et une électrode de groupe (GE), et pour déterminer la surface totale ou le nombre total des deuxièmes points de mesure (M21, M211) connectés, en fonction du courant de contrôle (I) et de la tension de contrôle (I).
